# EUROPEAN PATENT APPLICATION

(11) **EP 1 550 877 A1**
(43) Date of publication of application: **06.07.2005**
(21) Application number: 04030706.8
(22) Date of filing: 23.12.2004
(51) Int. Cl.: G01R 31/28, G01R 31/319

(54) **Differential active load**

(30) Priority: 31.12.2003 US 749600
(71) Applicant: TERADYNE, INC., Boston, Massachusetts 02118 (US)
(72) Inventor: Gohel, Tushar K., Wakefield MA 01880 (US)
(74) Representative: Wagner, Karl H., Dipl.-Ing.

(57) **Abstract**

A programmable active load is adapted for use with differential signals. The differential active load includes a diode quad having four terminals. A first programmable current source is connected to the first node and a second programmable current source is connected to the second node. The third and fourth nodes are respectively adapted to receive first and second differential signals of a differential pair of signals. The differential active load sources current to the more negative of the first and second differential signals, and sinks current from the more positive of the first and second differential signals.

## Description

### BACKGROUND OF THE INVENTION

### FIELD OF THE INVENTION

This invention relates generally to automatic test equipment for electronics ("ATE"), and, more particularly, to active load circuits for automatic test systems.

### DESCRIPTION OF RELATED ART

Automatic test systems commonly employ circuits for communicating electronic signals with units to be tested. Units under test ("UUT's") typically include many input/output nodes having similar electronic interface characteristics. Therefore, tester circuits that communicate with these nodes tend to be identical. Testers generally include tens or even hundreds or more of identical, general-purpose interface circuits known in the art as "pin electronics" circuits. Pin electronics circuits, also called "channels," can differ widely in construction, but most commonly include three basic elements: a driver, a detector, and a load.

The driver is a source of electronic signals. Typically, drivers are optimized for producing digital signals, which are either high (logic 1) or low (logic 0). Drivers are commonly designed to switch their outputs between high and low levels under strict timing control.

The detector is a receiver of electronic signals. It receives a signal from a UUT and indicates the state of that signal at particular instants in time.

The load is a dissipater of electrical energy. The energy is generally supplied by a UUT. The load subjects output signals of the UUT to loading conditions (e.g., current source and/or sink) that are similar to those expected during the UUT's normal operating conditions. Loads are generally programmable; the levels of currents they absorb (source and/or sink) can be adjusted.

Testers generally include timing circuitry for synchronizing drivers, detectors, and loads. Signals are generated, signals are detected, and loads are applied under strict timing control.

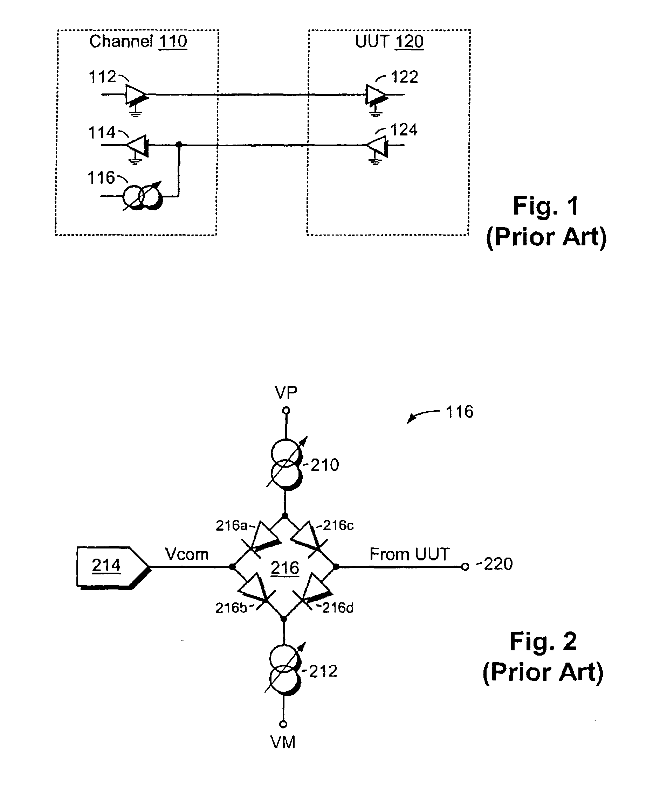

Fig. 1 shows a simplified schematic of a pin electronics channel 110 of the type described above, wherein the channel is connected to a UUT 120 for performing tests on the UUT. The channel includes a driver 112, a detector 114, and a load 116. Typically, the driver 112 supplies a test signal to a receiving circuit 122 of the UUT, such as the input of a latch. The detector 114 receives another test signal from an output circuit 124 of the UUT, such as the output of a latch. The load 116 typically also receives the other test signal and absorbs current from the output circuit 124. Testers generally include a great number of channels like the channel 110, and those channels can be connected to large numbers of input and output circuits of a UUT. This arrangement is merely an example of how a driver, detector, and load can be used when testing a device. Other arrangements are common.

Fig. 2 shows a more detailed view of a typical load 116. The load includes a pair of programmable current sources 210 and 212 that connect to opposite ends of a diode quad 216. One side of the diode quad 216 receives a programmable signal, VCOM, via a digital-to-analog converter 214. The other side of the diode quad (node 220) is adapted to receive a signal to be loaded from a UUT.

The programmable load 216 operates generally as follows. Assuming that the currents from the current sources 210 and 212 are equal and the node 220 is open, all current flowing into the top of the diode quad 216 flows out the bottom of the diode quad. The current divides approximately equally between the left and right sides of the diode quad, i.e., the same current flows through diodes 216a and 216b as flows through diodes 216c and 216d. Because all diodes 216a - 216d are conductive, the voltage VCOM applied to the left of the diode quad is approximately duplicated to the right of the diode quad.

If an output signal, such as from a UUT, is now applied to node 220, the balanced state of the diode quad is disturbed. When the voltage at node 220 exceeds VCOM, diode 216c is cut off (reverse-biased) and the current source 212 sinks all of its current from the UUT via diode 216d. Diode 216b is also cut off, and the current source 210 supplies all of its current to VCOM. When the voltage at node 220 is less than VCOM, diodes 216a and 216d are cut off. All current from the current source 210 is sourced to the UUT, and all the current to the current source 212 is sourced from VCOM.

The effect of this behavior is that the UUT sources the current of the current source 212 when its output is higher than VCOM, and sinks the current of current source 210 when its output is lower than VCOM.

The currents of the current sources 210 and 212 need not be the same. For instance, if the current through the current source 210 is greater than the current through the current source 212, the UUT is forced to sink a greater current when outputting a low signal than it is forced to source when outputting a high signal.

Traditionally, pin electronics channels have been designed for handling single-ended signals. As is known, "single-ended" signals are those that vary with respect to ground or some other DC level. For digital signals, the voltage of a single-ended signal with respect to ground determines whether the signal is high or low (e.g., 5V for high, 0V for low).

In recent years, the voltage at which integrated circuits operate has gotten smaller. Circuits running from 5V supplies have given way to those running from as little as 3 V. With logic voltages diminishing, the effects of noise on digital transmission has become more significant. Noise imposed on digital signals can cause a device to falsely trigger, if the noise crosses a switching threshold. To manage these effects, signals are increasingly being conveyed differentially rather than single-endedly.

It is also common to convey signals differentially in electrically noisy environments, regardless of the amplitudes of the signals. These environments include, for example, serial busses found in airplanes and weapons systems.

As is known, "differential" signals are pairs of signals that vary with respect to each other, irrespective of ground. A digital differential signal, nominally SIG and SIG*, is "high" when SIG is greater than SIG* and "low" when SIG is less than SIG*. Differential signals increase noise immunity by providing relatively large swings differentially even where the supply voltage is relatively small (e.g., 3V logic has a 6V differential swing). In addition, noise induced on differential signals tends to be predominantly common-mode, i.e., it affects both SIG and SIG* equally, but does not greatly affect the voltage difference between them.

As electronic designers increase their use of differential signals, ATE manufacturers are modifying their systems to better test these signals. For instance, various forms of differential circuits, such as differential drivers and detectors, have been incorporated into tester channels. Despite these improvements in drivers and detectors, the same active load of Fig. 2 continues to be used in differential applications. This is done with pairs of loads, in which one active load is connect to SIG and another is connected to SIG*.

Although this dual-load configuration is generally satisfactory, we have recognized a weakness in this approach: differential signals do not always maintain constant common-mode, or average, voltage levels with respect to ground. Because VCOM is ground-referenced, common-mode changes in a differential signal may cause the loads to turn on and off sporadically, even when the differential voltage between SIG and SIG* remains constant.

Another prior approach has been to use resistors between SIG and SIG*. This approach solves the common mode problem but does not allow for programmable load currents.

What is needed is a programmable active load circuit for differential signals that operates without regard to common-mode voltage.

### BRIEF SUMMARY OF THE INVENTION

With the foregoing background in mind, it is an object of the invention for an active load circuit to receive differential signals and operate substantially independently of common-mode voltage.

To achieve the foregoing object, as well as other objectives and advantages, a differential active load includes a current switching circuit, such as a diode quad, having first through fourth nodes. A sourcing current source is coupled to the first node, and a sinking current source is coupled to the second node. The third node is adapted to receive a first signal of a differential signal pair, and the fourth node is adapted to receive a second signal of a differential signal pair. The differential active load simultaneously sources current to the lesser of the signals of the differential signal pair and sinks current from the greater of the signals of the differential pair, substantially without regard to their voltages with respect to ground.

### BRIEF DESCRIPTION OF THE DRAWINGS

Additional objects, advantages, and novel features of the invention will become apparent from a consideration of the ensuing description and drawings, in which―
Fig. 1 is a simplified schematic of a pin electronics channel of an automatic test system connected to a unit under test for exercising the unit under test;
Fig. 2 is a simplified schematic of a programmable active load according to the prior art;
Fig. 3 is a simplified schematic of a differential pin electronics channel of an automatic test system connected to one or more differential devices on a unit under test, wherein the differential pin electronics channel includes a differential driver, a differential receiver, and a differential load according to the invention;
Fig. 4 is a simplified schematic of a programmable differential active load according to one embodiment of the invention; and
Fig. 5 is a flowchart of a process for testing a device with a test system equipped with a differential active load, such as the one shown in Fig. 4.

### DETAILED DESCRIPTION OF THE PREFERRED EMBODIMENT

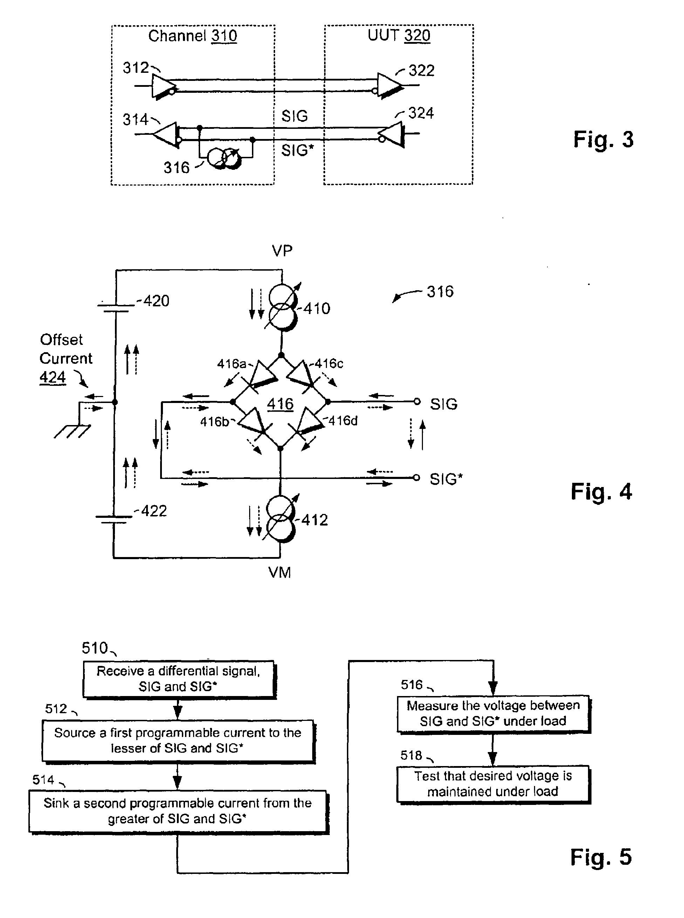

Fig. 3 shows an embodiment of the invention, wherein a pin electronics channel 310 for an automatic test system includes a differential load 316. The pin electronics channel 310 may also include a differential driver 312 and a differential detector 314, which are included merely for illustration. The differential load 316 is connected between two signals, nominally SIG and SIG*, which make up a differential pair of signals.

The differential load 316 presents a load to a device 324 on a UUT 320. When the voltage of SIG exceeds the voltage of SIG*, the differential load allows a substantially constant current to flow from SIG to SIG*. When the voltage of SIG is less than the voltage of SIG*, the differential load allows substantially the same current to flow in the opposite direction, from SIG* to SIG. The value of the constant current is preferably programmable. The differential load 316 thus presents a substantially constant load between SIG and SIG*, which always flows from the greater of the two signals to the lesser of the two signals.

Fig. 4 shows a more detailed view of the differential active load 316 according to an embodiment of the invention. The differential load 316 includes a current switching circuit, such as a diode quad 416. The diode quad is preferably constructed from four Schottky diodes. A first current source 410 is connected from a relatively positive supply voltage, VP, to a first node of the diode quad 416, for sourcing current into the first node. A second current source 412 is connected to a second node of the diode quad 416 and to a relatively negative supply voltage, VM, for sinking current from the second node. Third and fourth nodes of the diode quad 416 are connected to terminals of the active load, which are preferably adapted to receive signals SIG and SIG* from a UUT. Power supplies 420 and 422 respectively generate VP and VM. These power supplies are nominally referenced to ground. Alternatively, they could be referenced to another DC voltage, which is in turn referenced to ground. Depending on whether the currents of the sourcing and sinking current sources 410 and 412 are matched, an offset current 424 may flow to or from ground.

Arrows shown in Fig. 4 indicate directions of current flow through the active load 316. Solid arrows show the direction of current flow when SIG is greater than SIG*. Dotted arrows show the direction of current flow when SIG is less than SIG*.

When SIG is greater than SIG*, the current source 412 sinks current from SIG through a diode 416d of the diode quad, and the current source 410 sources current to SIG* through a diode 416a. Diodes 416b and 416c are cut off and remain nonconductive. Therefore, SIG sources substantially all the current of the current source 412 and SIG* sinks substantially all the current of the current source 410. When SIG is less than SIG*, the current source 412 sinks current from SIG* through a diode 416b of the diode quad, and the current source 410 sources current to SIG through a diode 416c. Diodes 416a and 416d are cut off. Therefore, in this state, SIG* sources substantially all the current of the current source 412 and SIG sinks substantially all the current of the current source 410.

If the currents of the current sources 410 and 412 are equal, a differential current load is imposed between SIG and SIG*, wherein any current that flows out of SIG flows back into SIG*, and any current that flows out of SIG* flows back into SIG. As shown, current flows between SIG and SIG* by flowing through the diode quad 416, through both current sources 410 and 412, and through both power supplies 420 and 422. If the currents are equal, the offset current 424 is zero.The differential load 316 is effective even if the currents of the current sources 410 and 412 are unequal. Here, the current flowing between SIG and SIG* is the sum of a differential component and an offset component. The differential component is the lesser of the currents of the two current sources 410 and 412. The offset component is the difference between the greater current and the lesser current. When the offset component is non-zero, a non-zero offset current 424 flows to or from ground to provide a return path for the offset component.

Often, UUT's are specified to source different maximum currents than they can sink. By deliberately imbalancing the sourcing and sinking currents of the active load 316, a test system can individually test a UUT's sourcing and sinking output specifications separately, even while providing a constant differential load between SIG and SIG*.

The active load 316 operates substantially independently of the common mode voltage of SIG and SIG*. Provided they are prevented from saturating, current sources 410 and 412 supply their programmed currents irrespective of the voltage at the first and second nodes of the diode quad. Therefore, programmed currents do not vary with changes in SIG and SIG*. SIG and SIG* can thus assume a wide range of common mode voltages without affecting the operation of the active load.

The current sources can be prevented from saturating by setting the supply voltages VP and VM to somewhat greater values than the maximum expected range of SIG and SIG*, and by designing the current sources to require low voltage overhead. These design techniques are well known in the art.

As indicated, the current sources 410 and 412 are preferably programmable, such as via a digital-to-analog converter (DAC), to provide currents that are suitable for testing UUTs with a wide range of devices. Fundamentally, however, the invention does not require that the current sources be programmable. For example, the current sources can provide fixed currents, e.g., for testing specific device types. In addition, one current source may be fixed while the other may be programmable. Both current sources may be programmed via a single programming source, such as a DAC, to establish the same programmed currents all the time, or they may be programmed individually via separate respective programming sources.

Significantly, the differential active load 316 differs from the single-ended active load 216 of the prior art by providing a load to two signals simultaneously instead of to one. The load is provided in true differential form, with current effectively flowing between SIG and SIG*. This is accomplished without duplication of the active load 216, one for each of SIG and SIG*, and without being adversely affected by changes in the common mode voltage of SIG and SIG*.

Fig. 5 shows how a differential active load according to the invention can be used in an actual test system for testing UUT's. At step 510, a differential active load receives a differential signal, nominally SIG and SIG*, from a UUT. The load sources a first current to the lesser of SIG and SIG* (step 512) and sinks a second current from the greater of SIG and SIG* (step 514). The first and second currents are preferably programmable and are set to values that load the UUT in such a way as to test that the UUT operates properly.

In a testing configuration like the one shown in Fig. 3, a detector receives SIG and SIG* from the UUT in parallel with the differential load. The detector is generally, although not necessarily, capable of measuring the differential voltage between SIG and SIG*. As SIG and SIG* change under the load provided by the differential load, the detector measures the voltage between SIG and SIG* (step 516).

Test programs that run on automatic test systems normally prescribe predetermined test limits, which define boundaries between acceptable device behavior and unacceptable behavior. A test limit may be prescribed for testing a differential voltage under load. The test program can compare the differential voltage between SIG and SIG* to the test limit (step 518). If the voltage is within the limit, the test passes. Otherwise, the test fails. In this context, being within the test limit means that the differential voltage does not collapse to an unacceptably small level under the load.

Although the differential active load has been described as part of a pin electronics channel, the invention is not limited to this application. The load may be used in other types of testing circuits or instruments, including specialized instruments for testing differential serial busses.

In addition, although the differential load 316 employs a diode quad 416 for switching its currents, this is not strictly required. Alternatively, any current switching circuit may be used that provides, between a pair of terminals, a current that changes direction in response to changes in the polarity of voltage between the terminals. The diode quad 416 may include greater numbers of diodes, e.g., the constituent diodes may be replaced with two or more diodes in series. Schottky diodes are preferred, but not strictly required. In addition, devices not commonly regarded as diodes, such as transistors or integrated circuits, which inherently include diode-like junctions, may also be used.

Therefore, while the invention has been particularly shown and described with reference to the preferred embodiments thereof, it will be understood by those skilled in the art that various changes in form and detail may be made therein without departing from the spirit and scope of the invention.

## Claims

1. A circuit for applying a load to first and second differential signals of a differential pair of signals, comprising:
a diode quad having first through fourth nodes;
a first current source coupled to the first node; and
a second current source coupled to the second node;
wherein the third and fourth nodes are adapted respectively to receive the first and second differential signals of the differential pair of signals.

2. A circuit as recited in claim 1, wherein at least one of the first and second current sources is programmable.

3. A circuit as recited in claim 1, wherein the first and second current sources are independently programmable.

4. A circuit as recited in claim 1, wherein one programming value establishes the current of both the first current source and the second current source.

5. A circuit as recited in claim 1, wherein the diode quad comprises four Schottky diodes.

6. A circuit as recited in claim 1, wherein the diode quad comprises four elements, each element comprising one or more diodes connected in series.

7. A circuit as recited in claim 1, wherein the diode quad comprises at least four semiconductor devices each having diode characteristics.

8. A circuit as recited in claim 1, wherein the first and second current sources are coupled to respective power supplies referenced to a common DC voltage.

9. A circuit as recited in claim 8, wherein the DC voltage is ground.

10. A pin electronics circuit for use in an automatic test system, comprising:
a differential load having first and second terminals that are connectable to nodes of a unit under test, the differential load including―
a diode quad having a first node coupled to a first current source,
a second node coupled to a second current source;
a third node coupled to the first terminal of the differential load, and
a fourth node coupled to the second terminal of the differential load.

11. A pin electronics circuit as recited in claim 10, wherein the diode quad comprises four Schottky diodes.

12. A pin electronics circuit as recited in claim 10, wherein the diode quad comprises four elements, each element comprising one or more diodes connected in series.

13. A pin electronics circuit as recited in claim 10, wherein the diode quad comprises at least four semiconductor devices each having diode characteristics.

14. A circuit as recited in claim 10, wherein the first and second current sources are coupled to respective power supplies referenced to a common DC voltage.

15. A method of applying a load for testing a unit under test in an automatic test system, comprising:
receiving a differential pair of signals, nominally SIG and SIG*, from the unit under test;
sinking a first current from the one of SIG and SIG* having the more positive voltage; and
sourcing a second current to the one of SIG and SIG* having the more negative voltage;

16. A method as recited in claim 15, further comprising:
measuring a voltage difference between SIG and SIG*; and
verifying that the measured voltage substantially matches an expected voltage difference between SIG and SIG*.

17. A method as recited in claim 16, further comprising:
indicating a passing result responsive to the measured voltage being within a predetermined tolerance range of the expected voltage difference; and
indicating a failing result responsive to the measured voltage being outside the predetermined tolerance range of the expected voltage.

18. A programmable active load for differential signals, comprising:
a first terminal for receiving a first voltage signal, nominally SIG, of a differential signal pair;
a second terminal for receiving a second voltage signal, nominally SIG*, of the differential signal pair; and
a current producing circuit, coupled to the first and second terminals, for producing a current between the first and second terminals, said current having a programmable value and a reversible direction, said direction being one direction when SIG is greater than SIG* and the opposite direction when SIG is less than SIG*.

19. A programmable active load as recited in claim 18, wherein the current producing circuit comprises:
a current switching circuit having first, second, third, and fourth nodes;
a first current source coupled to the first node of the current switching circuit; and
a second current source coupled to the second node of the current switching circuit,
wherein the third and fourth nodes of the current switching circuit are respectively coupled to the first and second terminals.

20. A programmable active load as recited in claim 19, wherein the current switching circuit comprises a diode quad.
